(19) Europäisches Patentamt
European Patent Office
Office européen des brevets

(11) **EP 3 571 767 B1**

(12) **FASCICULE DE BREVET EUROPEEN**

(45) Date de publication et mention
de la délivrance du brevet:
**23.06.2021 Bulletin 2021/25**

(21) Numéro de dépôt: **18700981.6**

(22) Date de dépôt: **09.01.2018**

(51) Int Cl.:
***H03K 17/955*** (2006.01)

(86) Numéro de dépôt international:
**PCT/EP2018/050444**

(87) Numéro de publication internationale:
**WO 2018/134081 (26.07.2018 Gazette 2018/30)**

(54) **DISPOSITIF CAPACITIF DE DETECTION D'UN OBJET ELECTRIQUEMENT FLOTTANT**

KAPAZITIVE VORRICHTUNG ZUR ERFASSUNG EINES ELEKTRISCH SCHWIMMENDEN OBJEKTS

CAPACITIVE DEVICE FOR DETECTING AN ELECTRICALLY FLOATING OBJECT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.01.2017 FR 1750515**

(43) Date de publication de la demande:
**27.11.2019 Bulletin 2019/48**

(73) Titulaire: **Fogale Nanotech**
**30900 Nimes (FR)**

(72) Inventeur: **ROZIERE, Didier**
**30900 Nîmes (FR)**

(74) Mandataire: **IPAZ**
**Parc Les Algorithmes, Bâtiment Platon**
**CS 70003 Saint-Aubin**
**91192 Gif-sur-Yvette Cedex (FR)**

(56) Documents cités:
**WO-A2-2015/144474      FR-A1- 3 032 287**
**US-A1- 2013 181 942      US-A1- 2014 360 854**

## Description

### Domaine technique

La présente invention concerne un dispositif capacitif de détection d'un objet électriquement flottant, ou dont le couplage avec un potentiel de référence tel qu'un potentiel de masse est insuffisant ou faible.

Le domaine de l'invention est, de manière non limitative, celui des interfaces de détection capacitive d'objets pour détecter les objets dans un environnement ou en contact avec une surface de détection.

### Etat de la technique

Il existe actuellement des capteurs capacitifs permettant de détecter un objet par rapport à une surface de détection, en mesurant un signal représentant la capacité formée entre une électrode de mesure et l'objet.

Ces capteurs comprennent une série d'électrodes de mesure, distribuées selon le plan de la surface de détection. Chaque électrode de mesure est gardée, par une électrode, dite de garde, polarisée à un potentiel alternatif, dit de garde, identique ou sensiblement identique au potentiel alternatif de l'électrode de mesure à au moins une fréquence de travail, et différent d'un potentiel de référence de l'électronique, tel qu'un potentiel de masse. Lorsque l'objet est à un potentiel différent du potentiel de garde, tel que le potentiel de masse, il se forme une capacité, dite électrode-objet, entre l'électrode de mesure et l'objet, représentative de la distance entre la surface de détection et l'objet.

Cependant, lorsque l'objet à détecter est isolé de son environnement, il n'est plus lié au potentiel de masse et son potentiel électrique s'éloigne du potentiel de masse. De plus, il peut alors se produire un couplage entre l'objet et les électrodes de mesure, de sorte que l'objet est polarisé avec le potentiel de garde et son potentiel s'éloigne encore plus du potentiel de masse. Dans ce cas, la sensibilité et la performance de détection du capteur sont dégradées. Une telle situation peut se produire, par exemple, lorsque l'objet est posé sur la surface de détection, telle qu'un matelas ou une table, et se trouve électriquement isolée de son environnement ou du sol.

Les documents FR3032287 A1 et US2013/181942 A1 représentent des exemples de l'état de la technique.

Un but de la présente invention est de remédier aux inconvénients précités.

Un autre but de la présente invention est de proposer un dispositif de détection par effet capacitif permettant de détecter un objet isolé de son environnement, avec plus de précision, lorsque le couplage de l'objet avec le potentiel de référence de l'électronique ou le potentiel de masse est dégradé.

Encore un autre but de la présente invention est de proposer un dispositif détection par effet capacitif permettant de détecter un objet isolé de son environnement, dont la sensibilité et la performance de détection ne sont pas dégradées, lorsque le couplage de l'objet avec le potentiel de référence de l'électronique ou le potentiel de masse est dégradé.

### Exposé de l'invention

Au moins un de ces buts est atteint avec un dispositif de détection d'un objet par rapport à une surface de détection, en particulier lorsque le couplage entre ledit objet et le potentiel de masse, ou le potentiel de référence de l'électronique dudit dispositif, est dégradé ou coupé, ledit dispositif comprenant les caractéristiques de la revendication 1.

Ainsi, le procédé selon l'invention permet de polariser l'objet à détecter au potentiel de masse ou à un potentiel de référence de l'électronique du dispositif selon l'invention, avec la ou les électrodes de polarisation. Par conséquent, lorsque le couplage entre l'objet à détecter et ledit potentiel de masse, ou de référence, est dégradé ou coupé, le potentiel de l'objet est ramené audit potentiel de masse (ou de référence) ou à un potentiel proche dudit potentiel de masse par la ou les électrode(s) de polarisation. Dans ces conditions, l'objet est détecté par les électrodes de mesure, avec plus de précision. De plus, en polarisant l'objet à détecter au potentiel de masse (ou de référence), la sensibilité et la performance de détection du dispositif selon l'invention sont moins, voire pas, dégradées, comparé aux dispositifs de l'art antérieur.

Dans la présente description, pour éviter des lourdeurs rédactionnelles, le terme « potentiel de masse » désigne un potentiel de référence de l'électronique, qui peut être par exemple une masse électrique ou un potentiel de masse. Ce potentiel de masse peut correspondre à un potentiel de terre, ou à un autre potentiel relié ou non au potentiel de terre.

Ou rappelle par ailleurs que de manière générale, les objets qui ne sont pas en contact électrique direct avec un potentiel électrique particulier (objets électriquement flottants) tendent à se polariser par couplage capacitif au potentiel électrique d'autres objets présents dans leur environnement, tel que par exemple la terre ou des électrodes, si les surfaces de recouvrement entre ces objets et ceux de l'environnement (ou les électrodes) sont suffisamment importantes.

Dans la présente demande, deux potentiels alternatifs sont identiques à une fréquence donnée lorsqu'ils comportent chacun une composante alternative identique à cette fréquence. Ainsi, l'un au moins des deux potentiels identiques à ladite fréquence peut comporter en outre une composante continue, et/ou une composante alternative de fréquence différente de ladite fréquence donnée.

De manière similaire, deux potentiels alternatifs sont différents à la fréquence de travail lorsqu'ils ne comportent pas de composante alternative identique à cette fréquence de travail.

Le dispositif selon l'invention comprend au moins une électrode de polarisation, disposée en regard de l'objet, et polarisée au potentiel de masse de sorte à polariser électriquement, par couplage capacitif, ledit objet se trouvant du côté de ladite surface de détection.

Suivant un mode de réalisation, au moins une, en particulier chaque, électrode de polarisation peut être disposée en regard de l'électrode de mesure.

Suivant un mode de réalisation, au moins une, en particulier chaque, électrode de polarisation peut être disposée en regard de l'électrode de garde.

Ces modes de réalisation présentent l'avantage de limiter le nombre de couches d'électrodes dans le dispositif selon l'invention, et ainsi de diminuer l'encombrement dudit dispositif.

Selon l'invention, au moins une, en particulier chaque, électrode de polarisation est disposée au même niveau que, ou sous, l'électrode de garde.

Ce mode de réalisation présente une complexité de réalisation diminuée.

Préférentiellement, l'électrode de polarisation peut être plus grande, ou plus large, que l'électrode de garde, elle-même plus large que l'électrode de mesure.

Ce mode de réalisation présente une sensibilité et une performance en détection améliorées car, d'une part l'électrode de mesure est efficacement gardée par l'électrode de garde, et d'autre part l'objet est efficacement polarisé au potentiel de masse par l'électrode de polarisation.

Dans tous les cas, il est important que l'électrode de polarisation ait une surface en regard avec l'objet.

Suivant des modes de réalisation, l'électrode de polarisation peut être disposée :

- selon une partie seulement de la surface de détection, et/ou
- à l'extérieur ou à part de la surface de détection.

Cette configuration peut permettre par exemple de polariser un objet étendu par rapport à la surface de détection (par exemple un corps humain).

Le dispositif selon l'invention peut comprendre une pluralité d'électrodes de mesure distribuées dans le plan de la surface de détection.

Suivant un mode de réalisation, le dispositif selon l'invention peut comprendre un commutateur d'électrodes permettant de relier sélectivement une ou des électrodes de mesures, soit au module de mesure pour en mesurer la capacité (électrode active), soit au potentiel de garde pour contribuer aux éléments de garde.

Ainsi, un module de mesure peut être utilisé pour interroger séquentiellement une pluralité d'électrodes de mesure.

Alternativement ou en plus, le dispositif selon l'invention peut comprendre des moyens de commutation permettant de commuter une ou des électrodes de mesure en électrodes de polarisation.

En particulier, le dispositif selon l'invention peut comprendre des moyens de commutation permettant de relier respectivement la ou les électrodes de mesure :

- soit à l'entrée du module de mesure (électrode active),
- soit à la garde,
- soit à la masse.

On peut notamment créer des zones d'électrodes de mesure, de garde et de polarisation. Ces zones peuvent se déplacer par commutation de chaque électrode de mesure.

En particulier, il est plus judicieux de séparer les électrodes de polarisation de la ou des électrodes de mesure actives avec des électrodes de garde afin de minimiser le couplage entre les électrodes de polarisation et de mesure.

Suivant un mode de réalisation, au moins une, en particulier chaque, électrode de polarisation peut être disposée entre deux électrodes de mesure adjacentes, et/ou entre deux électrodes de garde adjacentes.

Dans ce cas, l'électrode de polarisation peut se présenter sous la forme d'une piste ou d'une électrode fine.

L'électrode de polarisation est disposée, comme indiqué plus haut, au même niveau que, ou en dessous de, des électrodes de gardes.

Suivant un mode de réalisation, le dispositif peut comprendre pour au moins une, en particulier chaque, électrode de mesure une électrode de polarisation individuelle.

Alternativement, ou en plus, le dispositif selon l'invention peut comprendre, pour au moins deux, en particulier toutes les, électrodes de mesure une électrode de polarisation commune, en particulier formant un plan de masse.

Suivant un mode de réalisation, le dispositif peut comprendre pour au moins une, en particulier chaque, électrode de mesure une électrode de garde individuelle.

Alternativement, ou en plus, le dispositif selon l'invention peut comprendre, pour au moins deux, en particulier toutes les, électrodes de mesure une électrode de garde commune, en particulier formant un plan de de garde.

Suivant un mode de réalisation préféré, moins une, en particulier chaque, électrode de polarisation peut être ajourée, et l'électrode de garde peut être disposée dans la partie ajourée de ladite électrode de polarisation.

Ce mode de réalisation présente une compacité et une performance améliorées.

Avantageusement, l'une au moins, en particulier chacune, des électrodes de mesure, de garde et de polarisation peut être réalisée en un matériau transparent.

Par exemple, la ou les électrodes peuvent être réalisée(s) par exemple réalisée en Oxyde d'Indium Etain (ou ITO).

Les pistes de liaison de l'une au moins, en particulier de chacune, des électrodes peuvent être également être transparentes.

Par ailleurs, le dispositif selon l'invention peut comprendre un module de calcul agencé pour calculer la capacité électrode-objet, formée entre l'électrode de mesure et l'objet, en fonction du premier signal.

Le calcul de la capacité électrode-objet peut être réalisé en fonction du premier signal mesuré, ou en fonction d'une version numérisée dudit premier signal mesuré, ou d'un autre signal numérique ou analogique déduit dudit premier signal, par exemple par filtrage dudit premier signal à la fréquence de travail.

Le dispositif selon l'invention peut en outre comprendre au moins un module de calcul configuré pour déterminer une distance, ou un contact, entre l'objet et la surface de détection en fonction du premier signal, ou de la capacité électrode-objet.

Ce module de calcul peut, par exemple, être le module de calcul de la capacité électrode-objet, ou un autre module de calcul.

L'au moins un module de calcul peut déterminer ladite distance, ou ledit contact, par calcul ou par comparaison avec une table de référence préalablement établie, du premier signal ou de la capacité électrode-objet.

L'au moins un module de calcul peut déterminer ladite distance, ou ledit contact, directement en fonction du premier signal ou de la capacité électrode-objet, et d'une relation préalablement renseignée.

Suivant une version particulièrement avantageuse, l'électrode de mesure peut être séparée de l'électrode de garde d'une distance élastiquement modifiable, en particulier localement, par une pression ou une force exercée par l'objet sur ladite surface de détection.

Dans ce cas, l'électrode de mesure se rapproche de l'électrode de garde lorsqu'une pression ou une force est appliquée par l'objet sur la surface de détection. De plus, la distance séparant l'électrode de mesure de l'électrode de garde dépend de la pression ou de la force exercée par l'objet sur la surface de détection.

Dans cette version avantageuse, selon un mode de réalisation nullement limitatif, l'électrode de polarisation peut être positionnée au niveau de la surface de détection, et/ou au niveau de l'électrode de mesure.

Suivant un autre mode de réalisation, l'électrode de polarisation peut être positionnée au niveau de, ou en regard de, l'électrode de garde.

Dans cette version avantageuse, selon un mode de réalisation nullement limitatif, l'électrode de mesure peut être séparée de l'électrode de garde, par une couche élastiquement compressible, en particulier localement, comprenant, ou formée par, un matériau diélectrique.

Le diélectrique peut, par exemple, être :

- un fluide diélectrique : par exemple un gaz diélectrique tel que de l'air ou de l'azote, un liquide diélectrique tel que de l'huile, etc. ;

- un polymère diélectrique : par exemple un polymère à base de silicone ; ou

- une mousse diélectrique : par exemple une mousse en polyester.

La couche de séparation peut être transparente. A cet effet, il peut être réalisée, par exemple, en plastique souple transparent ou en PolyDiMethylSiloxane (ou PDMS) comprenant un diélectrique, lui-même transparent.

Suivant un exemple de réalisation, les électrodes peuvent être disposées dans ladite couche de séparation diélectrique.

Par exemple :

- la ou les électrodes de mesure peuvent être disposées dans la couche de séparation, du côté d'une paroi délimitant ladite couche de séparation du côté de la surface de détection. En particulier, la ou les électrodes de mesure peuvent être disposées solidaires de ladite paroi, par exemple déposées sur ladite paroi ; et/ou

- la ou les électrodes de polarisation peuvent être disposées dans la couche de séparation, du côté d'une paroi délimitant ladite couche de séparation du côté de la surface de détection, ou du côté d'une paroi délimitant ladite couche de séparation du côté opposé à la surface de détection. En particulier, la ou les électrodes de polarisation peuvent être disposées solidaires de ladite paroi, par exemple déposées sur ladite paroi ; et/ou

- la ou les électrodes de garde peuvent être disposées dans la couche de séparation, du côté d'une paroi délimitant ladite couche de séparation du côté opposé à la surface de détection. En particulier, la ou les électrodes de garde peuvent être disposées solidaires de ladite paroi, par exemple déposées sur ladite paroi.

Les électrodes de mesure, de garde et de polarisation peuvent être réalisées par exemple :

- à partir de circuits imprimés formant des électrodes et des pistes métalliques (PCB), souple ou rigide ;

- à partir d'un dépôt d'encre conductrice, déposée par exemple avec un procédé de sérigraphie ou de jet d'encre, sur une surface de matériau diélectrique ;

- à partir de couches de matériaux métalliques comme du cuivre, argent, ou d'autres matériaux conducteurs tels que du carbone ou des oxydes métalliques (Oxyde d'Indium Etain ou ITO, oxyde de zinc ou ZnO) déposées par un procédé de dépôt sous vide ou gravées par un procédé de gravure ;

- avec des polymères conducteurs ;

- sous la forme de tissu ou de couches de tissu, avec des fils en matériau conducteur (métal, ...) tissés ou tricotés....

Le dispositif selon l'invention peut en outre comprendre un module de mesure agencé pour mesurer un signal, dit deuxième signal, relatif à la capacité, dite inter-électrodes, formée entre l'électrode de mesure et l'électrode de garde, ladite électrode de garde étant préalablement polarisée à un potentiel différent du potentiel alternatif de l'électrode de mesure.

Un tel module de mesure peut être le module de mesure du premier signal. Alternativement, un tel module de mesure peut être différent du module de mesure du premier signal.

Par ailleurs, le dispositif selon l'invention peut comprendre un module de calcul agencé pour calculer la capacité inter-électrodes, formée entre l'électrode de mesure et l'électrode de garde, en fonction du deuxième signal.

Le calcul de la capacité inter-électrodes peut être réalisé en fonction du deuxième signal mesuré, ou en fonction d'une version numérisée dudit deuxième signal mesuré, ou encore en fonction d'un signal numérique ou analogique déduit dudit deuxième signal, par exemple par filtrage ou tout autre traitement analogique ou numérique.

Le dispositif selon l'invention peut en outre comprendre au moins un module de calcul configuré pour déterminer une pression ou une force appliquée par l'objet sur la surface de détection en fonction du deuxième signal, ou de la capacité inter-électrodes.

Ce module de calcul peut, par exemple, être un des modules de calcul décrit plus haut, ou un autre module de calcul.

L'au moins un module de calcul peut déterminer ladite pression, ou ladite force, par calcul ou par comparaison, avec une table de référence préalablement établie, du deuxième signal ou de la capacité inter-électrodes.

L'au moins un module de calcul peut déterminer ladite pression, ou ladite force, directement en fonction du deuxième signal, ou de ladite capacité inter-électrodes, et d'une relation préalablement renseignée.

Suivant encore un autre aspect de l'invention, il est proposé une couche de détection pour un équipement, munie d'un dispositif de détection selon l'invention.

Le dispositif de détection selon l'invention, en particulier les électrodes, peu(ven)t être intégré(es) dans la couche de détection.

La couche de détection peut être intégrée dans l'équipement.

Alternativement, la couche de détection peut être indépendante de l'équipement et rapportée sur cet équipement.

Suivant encore un autre aspect de l'invention, il est proposé un équipement muni d'une couche de détection selon l'invention.

Suivant des modes de réalisation, l'équipement peut comprendre, ou être de la forme, d'un support de réception d'une personne en position assise, ou allongée.

Un tel équipement peut être un mobilier pour recevoir une personne en position assise, tel qu'une chaise, ou un fauteuil, en particulier roulant.

Un tel équipement peut être un mobilier pour recevoir une personne en position allongée, tel qu'une table d'opération ou une table d'imagerie médicale, une civière, etc.

De manière nullement limitative, la couche de détection peut alors se présenter sous la forme d'un matelas ou d'une mousse, ou encore d'une alèse, d'une housse de protection ou d'un drap, pour un équipement comprenant un support de réception d'une personne en position assise, ou allongée, tel qu'un lit, une table, une chaise, un fauteuil, ou un fauteuil roulant.

L'objet à détecter peut être par exemple être un corps humain ou une partie d'un corps humain. En particulier, l'objet à détecter peut être une personne se trouvant en position allongée sur la surface de détection, ou en position assise sur/contre la surface de détection.

Suivant des modes de réalisation, l'équipement peut comprendre, ou être de la forme, d'un appareil électronique, tel que par exemple une pièce de robot ou un robot.

De manière nullement limitative, la couche de détection peut être disposée sur, ou intégrée dans, une surface ou une coque de l'appareil.

La couche de détection peut se présenter sous la forme d'un élément d'habillage ou d'une peau.

La couche de détection peut notamment se présenter sous la forme d'un élément d'habillage, tel qu'un textile d'habillage, indépendant dudit appareil.

La couche de détection peut aussi se présenter sous la forme d'une peau (ou « peau sensitive ») permettant de recouvrir tout ou partie d'un robot par exemple de forme humanoide. Cette peau peut être conçue de sorte à avoir un aspect (couleur, surface, touché...) proche de celle d'une peau humaine.

La couche de détection peut aussi se présenter sous la forme d'une pièce ou d'un élément d'habillage de forme tubulaire, apte à être disposée par exemple autour d'un membre ou d'une portion de membre d'un robot.

**Description des figures et modes de réalisation**

D'autres avantages et caractéristiques apparaîtront à l'examen de la description détaillée d'exemples nullement limitatifs, et des dessins annexés sur lesquels :

- la FIGURE 1 est une représentation schématique du principe électrique d'un premier exemple de réalisation non limitatif d'un dispositif selon l'invention ;
- la FIGURE 2 est une représentation schématique du principe électrique d'un deuxième exemple de réalisation non limitatif d'un dispositif selon l'invention ;
- les FIGURES 3a-3b sont des représentations schématiques du principe électrique d'un troisième exemple de réalisation non limitatif d'un dispositif se-

Ion l'invention ; et

- les FIGURES 4-10 sont des représentations schématiques de différentes configurations d'électrodes pouvant être mises en œuvre dans un dispositif selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

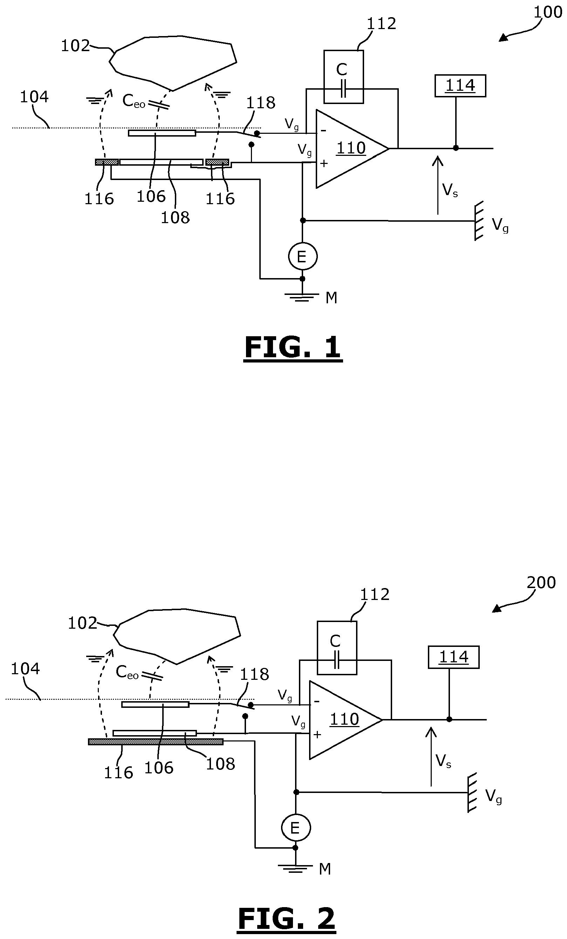

La FIGURE 1 est une représentation schématique du principe électrique d'un premier exemple de réalisation non limitatif d'un dispositif de détection selon l'invention.

Le dispositif 100, représenté de manière schématique sur la FIGURE 1, est prévu pour détecter l'approche et le contact d'un objet de commande 102 par rapport à une surface de détection 104.

Le dispositif 100 comprend au moins une électrode 106, dite de mesure, disposée face à la surface de détection 104, et donc à l'objet 102 s'approchant de ladite surface 104, et une électrode 108, dite de garde, disposée face à l'électrode de mesure 106, en dessous et à distance de l'électrode de mesure 106.

Le dispositif 100 comprend en outre un amplificateur de charge formé par un amplificateur opérationnel (AO) 110, dont la sortie est bouclée sur son entrée négative par une impédance 112, qui peut être un condensateur ou un condensateur associé à une résistance. Dans l'exemple représenté, l'impédance 112 est formée par un condensateur C.

Un module 114, numérique ou analogique, relié à la sortie de l'AO 110, mesure une tension électrique, notée $V_s$, sur la sortie de l'AO 110, à une fréquence de travail

Le dispositif 100 comprend en outre une source électrique E, dite de garde, fournissant un potentiel alternatif, dit de garde, noté $V_g$, différent d'une masse électrique, notée M et fréquence égale à la fréquence de travail.

Dans l'exemple représenté sur la FIGURE 1 :

- l'électrode de mesure 106 est reliée à l'entrée négative de l'AO 110, et
- l'électrode de garde est reliée à l'entrée positive de l'AO ; et
- la source électrique E est reliée à l'entrée positive de l'AO 110.

Dans cette configuration, l'électrode de mesure 106 et l'électrode de garde 108 sont au même potentiel (ou sensiblement au même potentiel) alternatif $V_g$, fournie par la source E.

Ainsi, l'électrode de garde 108 protège l'électrode de mesure 106 des couplages capacitifs parasites avec l'environnement et empêche l'apparition de capacités de fuite.

En outre, l'électronique de détection et en particulier l'AO 110 sont de préférence alimentés par une alimentation référencée au potentiel de garde $V_g$, pour éviter les capacités de fuite au niveau de l'électronique.

Alternativement, bien entendu, l'électronique de détection et en particulier l'AO 110 peuvent être alimentés par une alimentation référencée au potentiel de masse.

La tension $V_s$ mesurée par le module de mesure 114 est proportionnelle à la capacité $C_{eo}$, dite électrode-objet, formée entre l'électrode de mesure 106 et l'objet 102. En particulier, la tension $V_s$ mesurée vérifie la relation suivante :

$$V_s = E \frac{C_{eo}}{C} \ (1)$$

Ainsi, il est possible de déduire la capacité $C_{eo}$ à partir du signal $V_s$ mesuré.

De plus, la capacité $C_{eo}$ est directement fonction de la distance séparant l'objet 102 de l'électrode de mesure 106, et donc de la surface de détection 104. Par conséquent, il est possible de déduire la distance entre l'objet 102 et la surface de détection en fonction de la valeur de la capacité $C_{eo}$, et plus généralement en fonction du signal $V_s$.

Le dispositif 100 comprend en outre une autre électrode 116, dite électrode de polarisation. L'électrode de polarisation 116 est reliée à la masse électrique M et permet de polariser l'objet 102 avec le potentiel de masse M, de sorte à conserver la sensibilité et la performance de détection du dispositif 100, lorsque le couplage entre l'objet 102 et le potentiel de masse M est dégradé ou coupé. Une telle situation peut se produire lorsque l'objet 102 est uniquement en contact avec la surface de détection 104 ou lorsque l'objet 102 n'a aucun direct ou indirect avec le sol, autre que par la surface de détection 104.

Dans l'exemple représenté, l'électrode de polarisation 116 est ajourée et l'électrode de garde 108 est disposée dans la partie ajourée de l'électrode de polarisation 116, sans contact avec ladite électrode de polarisation 116. Ainsi, l'électrode de polarisation 116 et l'électrode de garde 108 sont disposées au même niveau.

L'électrode de polarisation 116 est plus grande que l'électrode de garde 108, elle-même plus grande que l'électrode de mesure 106

En outre, le dispositif 100 comprend un commutateur commandable 118 permettant de relier l'électrode de mesure 106 :

- soit à l'entrée négative de l'AO 110 : dans ce cas, l'électrode de mesure 106 est dite « active » et permet de mesurer un signal relatif à la capacité $C_{eo}$ ;
- soit au potentiel de garde $V_g$, présent par exemple à l'entrée positive de l'AO : dans ce cas, l'électrode de mesure 106 est reliée au même potentiel de garde $V_g$ que l'électrode de garde 108 et devient une électrode de garde.

Ainsi, il est possible d'interroger séquentiellement une pluralité d'électrodes de mesure 106, soit de manière individuelle, soit de manière groupée.

La FIGURE 2 est une représentation schématique du principe électrique d'un deuxième exemple de réalisation non limitatif d'un dispositif de détection selon l'invention.

Le dispositif 200, représenté sur la FIGURE 2, comprend tous les éléments du dispositif 100 de la FIGURE 1.

Dans le dispositif 200, à la différence du dispositif 100 de la FIGURE 1, l'électrode de polarisation 116 n'est pas ajourée, et est disposée sous l'électrode de garde 108, vue de l'électrode de mesure 106.

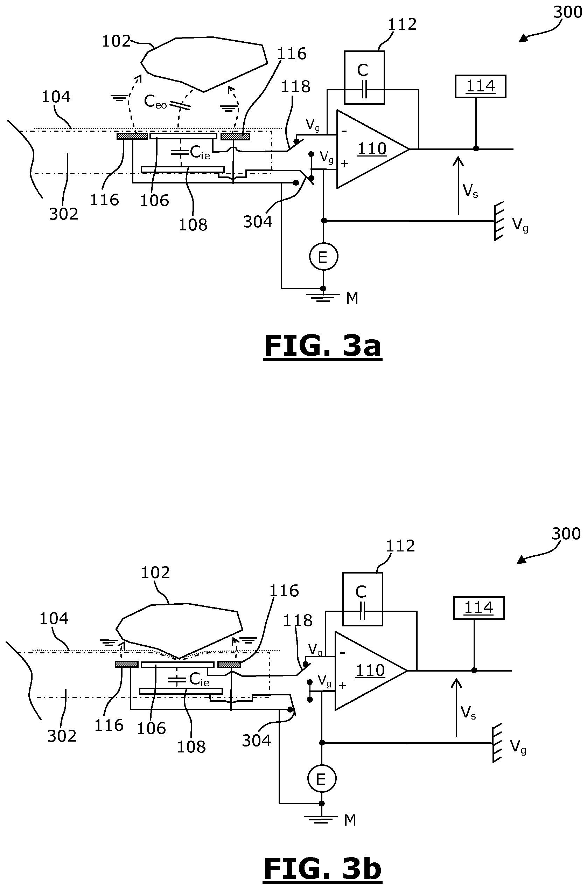

Les FIGURES 3a-3b sont des représentations schématiques du principe électrique d'un troisième exemple de réalisation non limitatif d'un dispositif de détection selon l'invention.

Le dispositif 300, représenté sur les FIGURES 3a-3b, est prévu pour détecter l'approche, le contact mais également l'appui exercé par l'objet de commande 102 sur la surface de détection 104.

L'objet 102 est en approche et à distance de la surface de détection 104 sur la FIGURE 3a, en appui sur la surface de détection 104 sur la FIGURE 3b.

Le dispositif 300 comprend tous les éléments du dispositif 100 de la FIGURE 1.

A la différence de la FIGURE 1, l'électrode de polarisation ajourée 116 est disposée au même niveau que l'électrode de mesure 106. Une telle architecture permet de minimiser les capacités parasites lors des mesures, en particulier dans le cas où l'électrode de polarisation 116 est éloignée de l'électrode de mesure 106 d'une distance comparable ou supérieure à l'espacement entre les électrodes de mesure 106 et de garde 108. Dans ce cas la garde 108 joue le rôle de garde de séparation entre l'électrode de mesure 106 et l'électrode de polarisation 116, même si elle n'est pas sur le même plan.

De plus, dans le dispositif 300, les électrodes de mesure 106, de garde 108 et de polarisation 116 sont disposées dans une couche 302, élastiquement compressible, remplie d'un diélectrique, tel que, par exemple, de la mousse ou du plastique ou encore un diélectrique liquide de type huile, ou encore un diélectrique gazeux de type air ou azote.

En particulier, l'électrode de mesure 106 et l'électrode de polarisation 116 sont solidaires de la paroi de la couche 302 du côté de la surface de détection 104, et sont par exemple déposées sur ladite paroi.

L'électrode de garde 108 est solidaire de la paroi de la couche 302 du côté opposé de la surface de détection 104, et est par exemple déposée sur ladite paroi.

Ainsi, la distance entre l'électrode de mesure 106 et l'électrode de garde 108 peut être modifiée, de manière élastique, localement, par une pression exercée par l'objet de commande 102 sur la surface de détection 104. En particulier, lorsqu'une pression est appliquée sur la surface de détection 104, l'électrode de mesure 106 se rapproche de l'électrode de polarisation 116, tel que représenté sur la FIGURE 3b.

Le dispositif 300 comprend en outre un commutateur 304 commandable permettant de relier l'électrode garde 108 :

- soit au potentiel de garde $V_G$ présent par exemple à l'entrée positive de l'AO 110 : dans ce cas l'électrode de garde 108 est polarisée au potentiel de garde $V_G$ ;
- soit au potentiel de masse électrique M.

Dans ces conditions, l'approche et le contact de l'objet 102 avec la surface de détection 104 sont détectés en fonction de la valeur de la capacité $C_{eo}$ formée entre l'électrode de mesure 106 et l'objet de commande 102. La capacité électrode-objet $C_{eo}$ est déterminée telle que décrit plus haut, en référence à la FIGURE 1 par exemple.

Le dispositif 300 permet en outre de mesurer la pression exercée par l'objet 102 sur la surface d'appui 104 en mesurant un signal, dit deuxième signal, représentatif d'une capacité $C_{ie}$, dite capacité inter-électrodes, formée entre l'électrode de mesure 106 et l'électrode de garde 108. Cette capacité inter-électrode $C_{ie}$ est déterminée de la manière suivante :

- l'électrode de mesure 106 reste reliée à l'entrée négative de l'AO 110 : dans cette configuration l'électrode de mesure 106 est active ; et
- l'électrode de garde 108 est reliée potentiel de masse électrique M grâce au commutateur 304 : dans cette configuration l'électrode de garde est polarisée à la masse électrique.

Lorsque l'objet de commande 102 arrive en contact avec la surface de détection 104, ou à proximité immédiate de cette surface (quasi-contact), la capacité $C_{eo}$ atteint une valeur seuil prédéterminée $C_s$ (ou une gamme de capacités de seuil). A ce moment-là, le commutateur commandable 304 est basculé de sorte à relier l'électrode de garde 108 au potentiel de masse M, tel que montré à la FIGURE 3b. Dans cette configuration, un deuxième signal $V_s$ est mesuré en sortie de l'AO 110. Ce deuxième signal $V_s$ est représentatif d'une capacité $C_T$, dite totale, vue par l'électrode de mesure 106, de sorte que :

$$V_s = V_g \frac{C_T}{C} \quad (2)$$

Cette relation (2) permet de déduire la valeur de la capacité totale $C_T$ à partir du deuxième signal $V_s$ mesuré.

Or, la capacité totale $C_T$ correspond à la somme :

- de la capacité électrode-objet $C_{eo}$, et
- de la capacité inter-électrodes $C_{ie}$ qui apparaît entre l'électrode de mesure 106 et la seconde électrode 108 du fait de leur différence de potentiel.

L'objet 102 étant au contact de la surface de commande 104, la capacité électrode-objet $C_{eo}$ ne varie plus et est toujours égale à (ou proche de) la capacité seuil $C_s$. Par conséquent, la valeur de la capacité inter-électrodes $C_{ie}$, représentative de l'appui de l'objet 102 sur la surface de détection 104 est obtenue par soustraction, suivant la relation suivante :

$$C_{ie} = C_T - C_s \quad (3),$$

ou

$$C_{ie} = C_T - C_{eoT} \quad (4),$$

Avec $C_{eoT}$ étant la capacité électrode objet mesurée avec l'objet en contact.

Dans cette configuration, il faut vérifier périodiquement si l'objet de commande 102 est toujours en contact avec la surface de détection 104. Pour cela, le commutateur commandable 304 est basculé périodiquement de sorte à relier l'électrode de garde 108 au potentiel de garde $V_g$ pour mesurer la capacité électrode-objet $C_{eo}$, puis à la masse M pour mesurer la capacité totale $C_T$, et donc la capacité inter-électrodes $C_{ie}$. Ces mesures séquentielles de $C_{eo}$ et $C_T$ sont réalisées tant que la capacité électrode-objet est supérieure à la capacité de seuil ($C_{eo} \geq C_s$).

En utilisant par exemple la loi du condensateur plan, on peut relier la capacité électrode-objet $C_{eo}$ et la capacité inter-électrodes $C_{ie}$ respectivement à une distance entre l'électrode de mesure et l'objet, et à une distance D entre l'électrode de mesure et l'électrode de garde. La pression peut alors être calculée à partir de la variation d'épaisseur D mesurée du matériau diélectrique remplissant la couche compressible 302, et de son module d'élasticité.

La détermination de chacune de ces capacités à partir des signaux mesurés peut être réalisée par le module de mesure 114, ou par un module de commande, ou encore par un ou plusieurs module(s) de calcul additionnels(s) (non représentés).

Pour cela, on peut mettre en œuvre un démodulateur synchrone qui réalise des fonctions de multiplication du signal $V_s$ issu de l'AO 110 avec un signal de porteuse correspondant au potentiel de garde $V_g$, puis de filtrage passe-bas.

On peut également utiliser un démodulateur asynchrone comprenant un redressement suivi d'un filtre passe-bas.

Bien entendu, l'utilisation du commutateur commandable 118 permet de d'interroger séquentiellement une pluralité d'électrodes de mesure 106, soit de manière individuelle, soit de manière groupée.

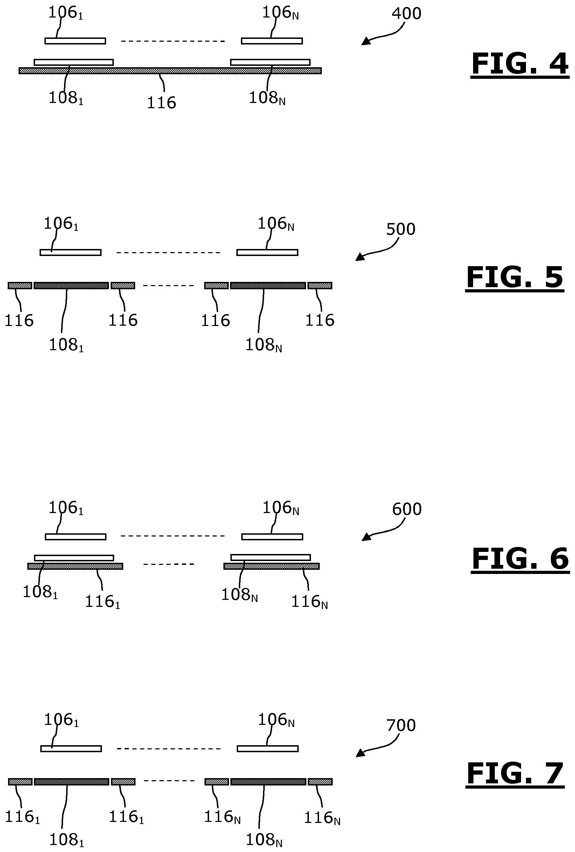

La FIGURE 4 est une représentation schématique d'une configuration d'électrodes pouvant être mise en œuvre dans un dispositif selon l'invention.

Dans la configuration 400, représentée sur la FIGURE 4, le dispositif comprend une pluralité d'électrodes de mesure $106_1$-$106_N$. Pour chaque électrode de mesure $106_1$-$106_N$, le dispositif comprend une électrode de garde individuelle, respectivement $108_1$-$108_N$.

Le dispositif 400 comprend en outre une unique électrode de polarisation 116, pour l'ensemble des électrodes de mesure $106_1$-$106_N$. L'unique électrode de polarisation 116 est disposée sous les électrodes de gardes $108_1$-$108_N$.

La FIGURE 5 est une représentation schématique d'une configuration alternative d'électrodes pouvant être mise en œuvre dans un dispositif selon l'invention.

Dans la configuration 500, représentée sur la FIGURE 5, le dispositif comprend une pluralité d'électrodes de mesure $106_1$-$106_N$. Pour chaque électrode de mesure $106_1$-$106_N$, le dispositif comprend une électrode de garde individuelle, respectivement $108_1$-$108_N$.

De plus, le dispositif 500 comprend en outre une unique électrode de polarisation 116, pour l'ensemble des électrodes de mesure $106_1$-$106_N$.

L'unique électrode de polarisation 116 est ajourée sous chaque électrode de mesure, respectivement $106_1$-$106_N$ et chaque électrode de garde, respectivement $108_1$-$108_N$, est disposée dans la partie ajourée de l'unique électrode de polarisation 116.

La FIGURE 6 est une représentation schématique d'une configuration d'électrodes pouvant être mise en œuvre dans un dispositif selon l'invention.

Dans la configuration 600, représentée sur la FIGURE 6, le dispositif comprend une pluralité d'électrodes de mesure $106_1$-$106_N$. Pour chaque électrode de mesure $106_1$-$106_N$, le dispositif comprend :

- une électrode de garde individuelle, respectivement

$108_1$-$108_N$ ; et

- une électrode de polarisation individuelle, respectivement $116_1$-$116_N$.

Chaque électrode de polarisation $116_i$ est disposée sous chaque électrode de garde $108_i$, vue de l'électrode de mesure $106_i$.

La FIGURE 7 est une représentation schématique d'une configuration d'électrodes pouvant être mise en œuvre dans un dispositif selon l'invention.

Dans la configuration 700, représentée sur la FIGURE 7, le dispositif comprend une pluralité d'électrodes de mesure $106_1$-$106_N$. Pour chaque électrode de mesure $106_1$-$106_N$, le dispositif comprend :

- une électrode de garde individuelle, respectivement $108_1$-$108_N$ ; et
- une électrode de polarisation individuelle, respectivement $116_1$-$116_N$.

Chaque électrode de polarisation $116_i$ est ajourée et chaque électrode de garde $108_i$ est disposée dans la partie ajourée de l'électrode de polarisation $116_i$, au même niveau que ladite électrode de polarisation $116_i$.

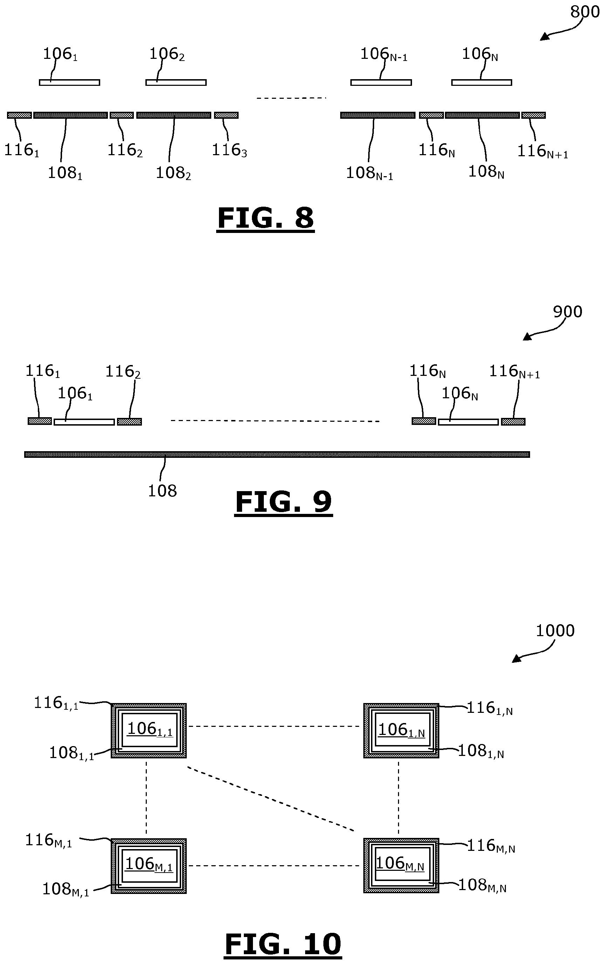

La FIGURE 8 est une représentation schématique d'une configuration d'électrodes pouvant être mise en œuvre dans un dispositif selon l'invention.

Dans la configuration 800, représentée sur la FIGURE 8, le dispositif comprend une pluralité d'électrodes de mesure $106_1$-$106_N$. Pour chaque électrode de mesure $106_1$-$106_N$, le dispositif comprend une électrode de garde individuelle, respectivement $108_1$-$108_N$.

Le dispositif comprend en outre (N+1) pistes/électrodes de polarisation $116_1$-$116_{(N+1)}$, disposées au même niveau que les électrodes de garde $108_1$-$108_N$. Chaque électrode de garde $108_i$, avec $1 \leq i \leq N$ est insérée entre deux pistes de polarisation $116_i$ et $116_{(i+1)}$.

Suivant une configuration alternative, les pistes de polarisation sont disposées uniquement entre les électrodes de garde. Autrement dit, le dispositif ne comprend pas les pistes de polarisation $116_1$ et $116_{(N+1)}$.

La FIGURE 9 est une représentation schématique d'une configuration d'électrodes pouvant être mise en œuvre dans un dispositif selon l'invention.

Dans la configuration 900, représentée sur la FIGURE 9, le dispositif comprend une pluralité d'électrodes de mesure $106_1$-$106_N$. Pour toutes les électrodes de mesure $106_1$-$106_N$, le dispositif comprend une seule et unique électrode de garde 108, commune à l'ensemble des électrodes de mesure $106_1$-$106_N$.

Le dispositif comprend en outre (N+1) pistes/électrodes de polarisation $116_1$-$116_{(N+1)}$, disposées au même niveau que les électrodes de mesure $106_1$-$106_N$. Chaque électrode de mesure $106_i$, avec $1 \leq i \leq N$ est insérée entre deux pistes de polarisation $116_i$ et $116_{(i+1)}$.

La FIGURE 10 est une représentation schématique d'une configuration d'électrodes pouvant être mise en œuvre dans un dispositif selon l'invention.

Dans la configuration 1000, représentée sur la FIGURE 10, le dispositif comprend une matrice de M lignes et de N colonnes d'électrodes de mesure $106_{i,j}$ avec $1 \leq i \leq M$ et $1 \leq j \leq N$. Pour chaque électrode de mesure, respectivement $106_{1,1}$-$106_{M,N}$, le dispositif comprend :

- une électrode de garde individuelle, respectivement $108_{1,1}$-$108_{M,N}$ ; et
- une électrode de polarisation individuelle, respectivement $116_{1,1}$-$116_{M,N}$.

Chaque électrode de polarisation $116_{i,j}$ est ajourée et chaque électrode de garde $108_{i,j}$ est disposée dans la partie ajourée de l'électrode de polarisation $116_{i,j}$, au même niveau que ladite électrode de polarisation $116_{i,j}$.

Suivant une configuration alternative, les électrodes de polarisation $116_{1,1}$-$116_{M,N}$ peuvent être rejointes pour former un unique plan, dit de polarisation.

Suivant encore une autre alternative, les électrodes de polarisation peuvent être remplacées par des lignes de polarisation, perpendiculaires entre-elles, et disposées entre les électrodes de garde.

Bien entendu, le dispositif peut comprendre un nombre d'électrodes/pistes de polarisation identique ou différent du nombre d'électrodes de mesure.

Bien sûr, l'invention n'est pas limitée aux exemples qui viennent d'être décrits et de nombreux aménagements peuvent être apportés à ces exemples sans sortir du cadre de l'invention.

**Revendications**

1. Dispositif (100;200;300) de détection d'un objet (102) par rapport à une surface de détection (104), ledit dispositif (100;200;300) comprenant :

    - au moins une électrode (106), dite de mesure, et
    - au moins une électrode (108), dite de garde, disposée en regard de ladite électrode de mesure (106), lesdites électrodes de mesure (106) et de garde (108) étant polarisées à un même potentiel alternatif ($V_g$), dit de garde, ou des potentiels alternatifs identiques à au moins une fréquence donnée, dite de travail, différent d'un potentiel de masse (M), et
    - au moins un module (114) de mesure d'un signal, dit premier signal, relatif à la capacité ($C_{eo}$), dite électrode-objet, formée entre ladite électrode de mesure (106) et ledit objet (102), et représentatif de la distance entre ledit objet (102) et ladite surface de détection ;

    **caractérisé en ce qu'**il comprend en outre au moins une électrode (116), dite de polarisation, disposée en regard de l'objet (102), et polarisée au potentiel de masse (M) de sorte à polariser électriquement, par couplage capacitif, ledit objet (102) ; et **en ce que** ladite, ou au moins une desdites, électrode(s) de polarisation (116) est disposée au même niveau que, ou sous, l'électrode de garde (108), vue de l'électrode de mesure.

2. Dispositif (100;300) selon la revendication précédente, **caractérisé en ce qu'**il comprend au moins une électrode de polarisation (116) disposée selon au moins l'une des configurations suivantes :

   - en regard de l'électrode de mesure (108),
   - en regard de l'électrode de garde (108).

3. Dispositif (100;200;300) selon la revendication 1, **caractérisé en ce que**, lorsque l'électrode de polarisation (116) est disposé sous l'électrode de garde, ladite électrode de polarisation (116) est plus grande, ou plus large, que l'électrode de garde (108), elle-même plus large que l'électrode de mesure (106).

4. Dispositif (100;200;300) selon l'une quelconque des revendications précédentes, **caractérisé en ce qu'**il comprend plusieurs électrodes de mesure, au moins une, en particulier chaque, électrode de polarisation étant disposée entre deux électrodes de mesure adjacentes, et/ou entre deux électrodes de garde adjacentes.

5. Dispositif (100;200;300) selon l'une quelconque des revendications précédentes, **caractérisé en ce qu'**il comprend, pour au moins une, en particulier chaque, électrode de mesure ($106_1$-$106_N$) une électrode de polarisation individuelle ($116_1$-$116_N$).

6. Dispositif (100;200;300) selon l'une quelconque des revendications 1 à 5, **caractérisé en ce qu'**il comprend, pour au moins deux, en particulier toutes les, électrodes de mesure ($106_1$-$106_N$) une électrode de polarisation commune (116), en particulier formant un plan de masse.

7. Dispositif (100;300) selon l'une quelconque des revendications précédentes, **caractérisé en ce qu'**au moins une, en particulier chaque, électrode de polarisation (116) est ajourée, l'électrode de garde (108) étant disposée dans la partie ajourée de ladite électrode de polarisation (116).

8. Dispositif (100;200;300) selon l'une quelconque des revendications précédentes, **caractérisé en ce qu'**il comprend au moins un module de calcul agencé pour calculer :

   - la capacité électrode-objet ($C_{eo}$), formée entre l'électrode de mesure (106) et l'objet (102), en fonction du premier signal ; et/ou
   - la distance, ou un contact, entre l'objet (102) et la surface de détection (104), en fonction dudit premier signal ou de ladite capacité électrode-objet (Ceo).

9. Dispositif (300) selon l'une quelconque des revendications précédentes, **caractérisé en ce que** l'électrode de mesure (106) est séparée de l'électrode de garde (108) d'une distance élastiquement modifiable, en particulier localement, par une pression ou une force exercée par l'objet (102) sur ladite surface de détection (104).

10. Dispositif (300) selon la revendication précédente, **caractérisé en ce que** l'électrode de mesure (106) est séparée de l'électrode de polarisation (116), et/ou de l'électrode de garde (108), par une couche (302) élastiquement compressible comprenant, ou formée par, un matériau diélectrique.

11. Dispositif (300) selon l'une quelconque des revendications 9 ou 10, **caractérisé en ce qu'**il comprend un module de mesure (114) agencé pour mesurer un deuxième signal relatif à la capacité ($C_{ie}$), dite inter-électrodes, formée entre l'électrode de mesure (106) et l'électrode de garde (108), ladite électrode de garde (108) étant polarisée à un potentiel différent du potentiel alternatif de l'électrode de mesure (106).

12. Dispositif (300) selon la revendication précédente, **caractérisé en ce qu'**il comprend au moins un module de calcul agencé pour calculer :

   - la capacité inter-électrodes ($C_{ie}$), formée entre l'électrode de mesure (106) et l'électrode de garde (108), en fonction du deuxième signal ; et/ou
   - la pression ou la force appliquée par l'objet (102) sur la surface de détection (104), en fonction dudit deuxième signal, ou de ladite capacité inter-électrodes ($C_{ie}$).

13. Couche de détection pour un équipement, munie d'un dispositif de détection (100;200;300) selon l'une quelconque des revendications précédentes.

14. Couche de détection selon la revendication précédente, se présentant sous la forme d'un matelas ou d'une mousse pour un équipement comprenant un support de réception d'une personne en position assise, ou allongée.

15. Couche de détection selon la revendication 13, se présentant sous la forme d'un élément d'habillage ou d'une peau pour un équipement comprenant un appareil électronique.

**16.** Équipement muni d'une couche de détection selon l'une quelconque des revendications 13 à 15.


**Patentansprüche**

**1.** Vorrichtung (100;200;300) zur Erfassung eines Objekts (102) in Bezug auf eine Erfassungsfläche (104), wobei die genannte Vorrichtung (100;200;300) umfasst:

> - mindestens eine Elektrode (106), die als Messelektrode bezeichnet wird, und
> - mindestens eine Elektrode (108), die als Schutzelektrode bezeichnet wird, und die gegenüber der genannten Messelektrode (106) angeordnet ist, wobei die genannte Messelektrode (106) und Schutzelektrode (108) polarisiert sind auf dasselbe Wechselpotential ($V_g$), das als Schutzpotential bezeichnet wird, oder auf identische Wechselpotentiale bei mindestens einer gegebenen Frequenz, die als Arbeitsfrequenz bezeichnet wird, und die von einem Massepotential (M) verschieden ist, und
> - mindestens ein Modul (114) zur Messung eines Signals, das als erstes Signal bezeichnet wird, relativ zur Kapazität (Ceo), die als Elektrode-Objekt-Kapazität bezeichnet wird, die zwischen der genannten Messelektrode (106) und dem genannten Objekt (102) gebildet wird, und die für die Distanz zwischen dem genannten Objekt (102) und der genannten Erfassungsfläche repräsentativ ist;

**dadurch gekennzeichnet, dass** sie außerdem mindestens eine Elektrode (116) umfasst, die als Polarisationselektrode bezeichnet wird, die gegenüber dem Objekt (102) angeordnet ist, und die auf das Massepotential (M) polarisiert ist, um elektrisch, durch kapazitive Kopplung, das genannte Objekt (102) zu polarisieren;
und dadurch, dass die genannte, oder mindestens eine der genannten, Polarisationselektrode(n) (116) auf derselben Höhe wie die, oder unter der, Schutzelektrode (108) angeordnet ist, gesehen von der Messelektrode.

**2.** Vorrichtung (100;300) nach dem vorhergehenden Anspruch, **dadurch gekennzeichnet, dass** sie mindestens eine Polarisationselektrode (116) umfasst, die gemäß mindestens einer der folgenden Auslegungen angeordnet ist:

> - gegenüber der Messelektrode (108),
> - gegenüber der Schutzelektrode (108).

**3.** Vorrichtung (100;200;300) nach Anspruch 1, **dadurch gekennzeichnet, dass**, wenn die Polarisationselektrode (116) unter der Schutzelektrode angeordnet ist, die genannte Polarisationselektrode (116) größer, oder breiter, ist als die Schutzelektrode (108), die selbst breiter ist als die Messelektrode (106).

**4.** Vorrichtung (100;200;300) nach einem der vorhergehenden Ansprüche, **dadurch gekennzeichnet, dass** sie mehrere Messelektroden umfasst, wobei mindestens eine, insbesondere jede, Polarisationselektrode zwischen zwei benachbarten Messelektroden und/oder zwischen zwei benachbarten Schutzelektroden angeordnet ist.

**5.** Vorrichtung (100;200;300) nach einem der vorhergehenden Ansprüche, **dadurch gekennzeichnet, dass** sie für mindestens eine, insbesondere jede, Messelektrode ($106_1$-$106_N$) eine einzelne Polarisationselektrode ($116_1$-$116_N$) umfasst.

**6.** Vorrichtung (100;200;300) nach einem der Ansprüche 1 bis 5, **dadurch gekennzeichnet, dass** sie für mindestens zwei, insbesondere alle, Messelektroden ($106_1$-$106_N$) eine gemeinsame Polarisationselektrode (116) umfasst, wobei insbesondere eine Masseebene gebildet wird.

**7.** Vorrichtung (100;300) nach einem der vorhergehenden Ansprüche, **dadurch gekennzeichnet, dass** mindestens eine, insbesondere jede, Polarisationselektrode (116) durchbrochen ist, wobei die Schutzelektrode (108) in dem durchbrochenen Teil der genannten Polarisationselektrode (116) angeordnet ist.

**8.** Vorrichtung (100;200;300) nach einem der vorhergehenden Ansprüche, **dadurch gekennzeichnet, dass** sie mindestens ein Berechnungsmodul umfasst, das dafür eingerichtet ist, um zu berechnen:

> - die Elektrode-Objekt-Kapazität (Ceo), die zwischen der Messelektrode (106) und dem Objekt (102) gebildet wird, als Funktion des ersten Signals; und/oder
> - die Distanz, oder einen Kontakt, zwischen dem Objekt (102) und der Erfassungsfläche (104), als Funktion des genannten ersten Signals oder der genannten Elektrode-Objekt-Kapazität (Ceo).

**9.** Vorrichtung (300) nach einem der vorhergehenden Ansprüche, **dadurch gekennzeichnet, dass** die Messelektrode (106) von der Schutzelektrode (108) um eine Distanz getrennt ist, die, insbesondere lokal, durch einen Druck oder eine Kraft, die von dem Objekt (102) auf die genannte Erfassungsfläche (104) ausgeübt werden, elastisch modifizierbar

**10.** Vorrichtung (300) nach dem vorhergehenden Anspruch, **dadurch gekennzeichnet, dass** die Messelektrode (106) von der Polarisationselektrode (116), und/oder der Schutzelektrode (108), durch eine elastisch zusammendrückbare Schicht (302) getrennt ist, die ein dielektrisches Material umfasst oder daraus gebildet ist.

**11.** Vorrichtung (300) nach einem der Ansprüche 9 oder 10, **dadurch gekennzeichnet, dass** sie ein Messmodul (114) umfasst, das dafür eingerichtet ist, um ein zweites Signal relativ zur Kapazität ($C_{ie}$) zu messen, die als Zwischenelektrodenkapazität bezeichnet wird, und die zwischen der Messelektrode (106) und der Schutzelektrode (108) gebildet wird, wobei die genannte Schutzelektrode (108) auf ein anderes Potential polarisiert ist als das Wechselpotential der Messelektrode (106).

**12.** Vorrichtung (300) nach dem vorhergehenden Anspruch, **dadurch gekennzeichnet, dass** sie mindestens ein Berechnungsmodul umfasst, das dafür eingerichtet ist, um zu berechnen:

- die Zwischenelektrodenkapazität ($C_{ie}$), die zwischen der Messelektrode (106) und der Schutzelektrode (108) gebildet wird, als Funktion des zweiten Signals; und/oder
- den Druck oder die Kraft, die von dem Objekt (102) auf die Erfassungsfläche (104) ausgeübt werden, als Funktion des genannten zweiten Signals, oder der genannten Zwischenelektrodenkapazität ($C_{ie}$).

**13.** Schicht zur Erfassung für eine Ausrüstung, welche mit einer Vorrichtung zur Erfassung (100;200;300) nach einem der vorhergehenden Ansprüche versehen ist.

**14.** Schicht zur Erfassung nach dem vorhergehenden Anspruch, welche sich in der Form einer Matte oder eines Schaums für eine Ausrüstung darstellt, die einen Empfangsträger einer Person in sitzender oder liegender Position umfasst.

**15.** Schicht zur Erfassung nach Anspruch 13, welche sich in der Form eines Kleidungsstücks oder einer Haut für eine Ausrüstung darstellt, die ein elektronisches Gerät umfasst.

**16.** Ausrüstung, welche mit einer Schicht zur Erfassung nach einem der Ansprüche 13 bis 15 versehen ist.

**Claims**

**1.** A device (100;200;300) for detecting an object (102) with respect to a detection surface (104), said device (100;200;300) comprising:

- at least one electrode (106), called measurement electrode, and
- at least one electrode (108), called guard electrode, placed facing said measurement electrode (106), said measurement (106) and guard (108) electrodes being polarized at one and the same alternating potential ($V_g$), called guard potential, or alternating potentials identical at at least one given frequency, called working frequency, different from a ground potential (M), and
- at least one module (114) for measuring a signal, called first signal, with respect to the capacitance ($C_{eo}$), called electrode-object capacitance, formed between said measurement electrode (106) and said object (102), and representative of the distance between said object (102) and the detection surface;

**characterized in that** it also comprises at least one electrode (116), called polarization electrode, placed facing the object (102), and polarized at the ground potential (M) so as to electrically polarize said object (102) by capacitive coupling;
and **in that** said, or at least one of said, polarization electrode(s) (116) is placed at the level as, or below, the guard electrode (108), seen from the measurement electrode.

**2.** The device (100;300) according to the preceding claim, **characterized in that** it comprises at least one polarization electrode (116) placed according to at least one of the following configurations:

- facing the measurement electrode (106);
- facing the guard electrode (108).

**3.** The device (200) according to claim 1, **characterized in that**, when the polarization electrode (200) is placed below the guard electrode (108), said polarization electrode (116) is larger, or wider, than the guard electrode (108), itself larger than the measurement electrode (106).

**4.** The device (100;200;300) according to any one of the preceding claims, **characterized in that** it comprises several measurement electrodes, at least one, in particular each, polarization electrode being placed between two adjacent measurement electrodes, and/or between two adjacent guard electrodes.

**5.** The device (100;200;300) according to any one of the preceding claims, **characterized in that** it comprises, for at least one, in particular each, measurement electrode ($106_1$-$106_N$) an individual polariza-

tion electrode ($116_1$-$116_N$).

6. The device (100;200;300) according to any one of claims 1 to 5, **characterized in that** it comprises, for at least two, in particular all, measurement electrodes ($106_1$-$106_N$), a common polarization electrode (116), in particular forming a ground plane.

7. The device (100;300) according to any one of the preceding claims, **characterized in that** at least one, in particular each, polarization electrode (116) is openwork, the guard electrode (108) being placed in the openwork part of said polarization electrode (116).

8. The device (100;200;300) according to any one of the preceding claims, **characterized in that** it comprises at least one calculation module arranged in order to calculate:

   - the electrode-object capacitance ($C_{eo}$), formed between the measurement electrode (106) and the object (102), as a function of the first signal; and/or
   - the distance, or a contact, between the object (102) and the detection surface (104) as a function of said first signal or of said electrode-object capacitance (Ceo).

9. The device (300) according to any one of the preceding claims, **characterized in that** the measurement electrode (106) is separated from the guard electrode (108) by a distance that is elastically modifiable, in particular locally, by a load or a force exerted by the object (102) on said detection surface (104).

10. The device (300) according to the preceding claim, **characterized in that** the measurement electrode (106) is separated from the polarization electrode (116), and/or from the guard electrode (108), by a layer (302) that is elastically compressible comprising, or formed by, a dielectric material.

11. **The** device (300) according to any one of claims 9 or 10, **characterized in that** it comprises a measurement module (114) arranged in order to measure a second signal with respect to the capacitance ($C_{ie}$), called inter-electrode capacitance, formed between the measurement electrode (106) and the guard electrode (108), said guard electrode (108) being polarized at a potential different from the alternating potential of the measurement electrode (106).

12. The device (300) according to the preceding claim, **characterized in that** it comprises at least one calculation module arranged in order to calculate:

   - the inter-electrode capacitance ($C_{ie}$), formed between the measurement electrode (106) and the guard electrode (108), as a function of the second signal; and/or
   - the load or the force applied by the object (102) on the detection surface (104) as a function of said second signal, or of said inter-electrode capacitance ($C_{ie}$).

13. A detection layer, for an item of equipment, equipped with a detection device (100;200;300) according to any one of the preceding claims.

14. The detection layer according to the preceding claim, having the form of a mattress or a foam material for an item of equipment comprising a support for receiving a person in a seated or lying position.

15. **The** detection layer according to claim 13, having the form of a trim element or a skin for an item of equipment comprising an electronic appliance.

16. An item of equipment equipped with a detection layer according to any one of claims 13 to 15.

**FIG. 1**

**FIG. 2**

**FIG. 3a**

**FIG. 3b**

$106_1$      $106_N$      400

$108_1$      116      $108_N$

**FIG. 4**

$106_1$      $106_N$      500

116      116      116      116

$108_1$      $108_N$

**FIG. 5**

$106_1$      $106_N$      600

$108_1$      $116_1$      $108_N$      $116_N$

**FIG. 6**

$106_1$      $106_N$      700

$116_1$      $116_1$      $116_N$      $116_N$

$108_1$      $108_N$

**FIG. 7**

800

$106_1$    $106_2$    $106_{N-1}$    $106_N$

$116_1$    $116_2$    $116_3$    $116_N$    $116_{N+1}$

$108_1$    $108_2$    $108_{N-1}$    $108_N$

**FIG. 8**

900

$116_1$    $116_2$    $116_N$    $116_{N+1}$

$106_1$    $106_N$

108

**FIG. 9**

1000

$116_{1,1}$    $106_{1,1}$    $106_{1,N}$    $116_{1,N}$

$108_{1,1}$    $108_{1,N}$

$116_{M,1}$    $106_{M,1}$    $106_{M,N}$    $116_{M,N}$

$108_{M,1}$    $108_{M,N}$

**FIG. 10**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3032287 A1

- US 2013181942 A1